Europäisches Patentamt

European Patent Office

Office européen des brevets

(19)

(11) Veröffentlichungsnummer: **0 254 961**
**B1**

(12) # EUROPÄISCHE PATENTSCHRIFT

(45) Veröffentlichungstag der Patentschrift:
**15.11.89**

(21) Anmeldenummer: **87110228.1**

(22) Anmeldetag: **15.07.87**

(51) Int. Cl.⁴: **C23G 3/00**

(54) **Behandlungseinrichtung, insbesondere für im horizontalen Durchlauf zu behandelnde Leiterplatten.**

(30) Priorität: **28.07.86 DE 3625423**

(43) Veröffentlichungstag der Anmeldung:
**03.02.88 Patentblatt 88/5**

(45) Bekanntmachung des Hinweises auf die Patenterteilung:
**15.11.89 Patentblatt 89/46**

(84) Benannte Vertragsstaaten:
**AT BE CH DE FR GB IT LI NL SE**

(56) Entgegenhaltungen:
**US-A- 2 418 934**

(73) Patentinhaber: **Siemens Aktiengesellschaft,
Wittelsbacherplatz 2, D-8000 München 2(DE)**

(72) Erfinder: **Hosten, Daniel, Staatsbaan 147,
B-8120 Handzame (Kortemark)(BE)**

## Beschreibung

Die Erfindung betrifft eine Behandlungseinrichtung, insbesondere für im horizontalen Durchlauf zu behandelnde Leiterplatten, mit einer Behandlungszelle welcher Behandlungsflüssigkeit aus einem Vorratsbehälter mittels einer Pumpe zuführbar ist und mit einer in den Vorratsbehälter einmündenden Abflußleitung für aus der Behandlungszelle austretende Behandlungsflüssigkeit.

Derartige Behandlungseinrichtungen mit einer kontinuierlichen Umwälzung der Behandlungsflüssigkeit werden insbesondere in der Galvanotechnik für die Vorbehandlung, Metallisierung und Nachbehandlung von Werkstücken eingesetzt. Ein Einsatz bei der stromlosen Metallisierung von Werkstücken ist ebenfalls möglich. Je nach Art der verwendeten Behandlungsflüssigkeit kann es beim Abfluß in den Vorratsbehälter zu einem Einarbeiten von Luft in die Behandlungsflüssigkeit und zu einer Schaumbildung im Vorratsbehälter kommen. Insbesondere bei Behandlungsflüssigkeiten mit hohen Netzmittelgehalten, wie z. B bei den zur Vorbereitung von stromlosen Metallabscheidungen verwendeten Reiniger-/Konditionierlösungen oder bei Elektrolytlösungen zum galvanischen Abscheiden von Zinn kann eine derart starke Schaumbildung auftreten, daß der Schaum in größeren Mengen aus dem Vorratsbehälter austritt.

Bei im horizontalen Durchlauf zu behandelnden Leiterplatten wird eine intensive Durchflutung der Durchkontaktierungslöcher durch eine besonders intensive Umwälzung der jeweiligen Behandlungsflüssigkeiten er reicht. Mit der erhöhten Umwälzung wird dann jedoch auch die unerwünschte Schaumbildung noch weiter begünstigt.

Schaumverhütungsmittel sind Substanzen, die schäumenden Flüssigkeiten zugesetzt werden, um die Schaumbildung zu reduzieren oder zu verhindern. Die Schaumverhütungsmittel sind entweder grenzflächenaktive Stoffe, die die Schaumbildner aus der Grenzfläche verdrängen, ohne selbst Schaumbildner zu sein, oder aber Produkte, die die Oberflächenspannung der Flüssigkeit erhöhen. Bei den geschilderten Behandlungseinrichtungen würde die Zugabe derartiger Schaumverhütungsmittel die Eigenschaften der jeweiligen Behandlungslösungen jedoch erheblich beeinträchtigen. Eine Bekämpfung der Schaumbildung mit chemischen Mitteln muß somit ausgeschlossen werden.

Der Erfindung liegt die Aufgabe zugrunde, bei einer Behandlungseinrichtung der eingangs genannten Art die Schaumbildung im Vorratsbehälter zu reduzieren oder zu verhindern.

Diese Aufgabe wird erfindungsgemäß dadurch gelöst, daß die Abflußleitung an ein im Vorratsbehälter angeordnetes Verteilerrohr angeschlossen ist und daß das Verteilerrohr mit mindestens einem oberhalb des Flüssigkeitsspiegels angeordneten Austrittsschlitz ausgerüstet ist.

Der Erfindung liegt die Erkenntnis zugrunde, daß ein Verteilerrohr mit einem knapp über dem Flüssigkeitsspiegel im Vorratsbehälter liegenden Austrittsschlitz das Entweichen von Luft oder Gasen begünstigt. Andererseits wird durch den Austrittsschlitz der Austrittsquerschnitt vergrößert, so daß die entsprechend verringerte Austrittsgeschwindigkeit ebenfalls eine Reduzierung der Schaumbildung bewirkt.

Gemäß einer bevorzugten Ausgestaltung der Erfindung ist vorgesehen, daß die Abflußleitung über einen U-förmigen Bogen von unten her in das Verteilerrohr einmündet. Durch eine derartige als Siphon ausgebildete Einmündung der Abflußleitung kann eine Schaumbildung in noch stärkerem Maße gebremst werden.

Weiterhin hat es sich als günstig herausgestellt, wenn das Verteilerrohr die Form eines geschlossenen Ringes aufweist. Hierdurch kann der Austrittsquerschnitt weiter vergrößert werden. Zur Vergrößerung des Austrittsquerschnitts ist es dann auch zweckmäßig, wenn das Verteilerrohr mit einem durchgehenden Austrittschlitz ausgerüstet ist.

Im Hinblick auf die Entgasungsfunktion des Austrittsschlitzes ist es auch besonders vorteilhaft, wenn das Verteilerrohr einen runden oder ovalen Querschnitt aufweist.

Gemäß einer weiteren besonders bevorzugten Ausgestaltung der Erfindung ist in der Abflußleitung ein Regulierventil angeordnet. Ein derartiges Regulierventil kann dann so eingestellt werden, daß in der Abflußleitung eine bis zum Behälterauslauf reichende Flüssigkeitssäule aufgebaut wird. Durch eine derart hohe Flüssigkeitssäule wird dann bereits im Behälterauslauf ein Einarbeiten von Luft nach dem Prinzip der Wasserstrahlpumpe mit Sicherheit verhindert.

Schließlich hat es sich auch als zweckmäßig erwiesen, wenn in der Zuführleitung zwischen Pumpe und Vorratsbehälter ein Regulierventil angeordnet ist. Dieses Regulierventil ermöglicht dann eine besonders einfache und genaue Einstellung des Flüssigkeitspegels, der ja dicht unter dem Austrittsschlitz liegen soll.

Ein Ausführungsbeispiel der Erfindung ist in der Zeichnung dargestellt und wird im folgenden näher beschrieben.

Es zeigen

Fig. I eine Behandlungseinrichtung für im horizontalen Durchlauf zu behandelnde Leiterplatten in stark vereinfachter schematischer Darstellung und

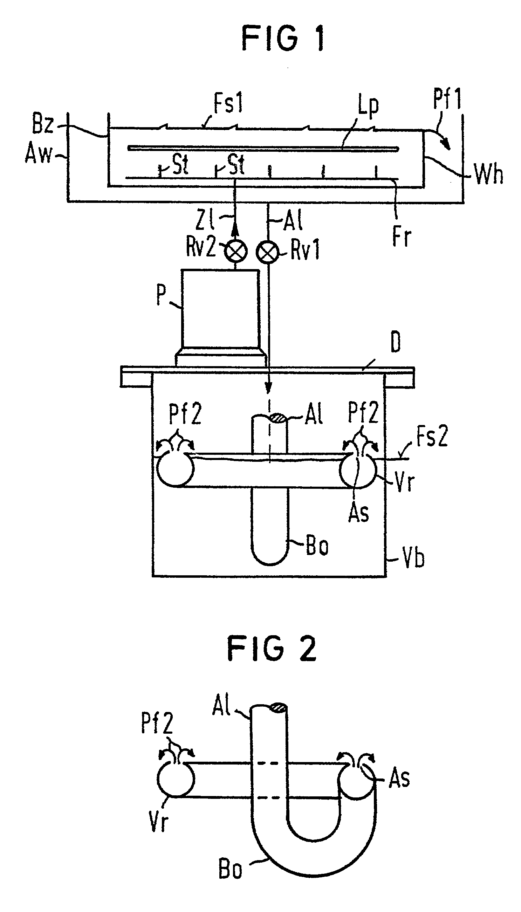

Fig. 2 die siphonartige Einmündung des Abflußrohres in das Verteilerrohr der in Fig. I dargestellten Behandlungseinrichtung.

Fig. I zeigt eine Behandlungseinrichtung für Leiterplatten Lp, die mit Hilfe von nicht näher dargestellten Transportrollen in horizontaler Richtung durch eine mit Bz bezeichnete Behandlungszelle geführt werden. Die Zufuhr der in einem Vorratsbehälter Vb enthaltenen Behandlungsflüssigkeit erfolgt mit Hilfe einer Pumpe P, deren im Vorratsbehälter Vb liegendes Ansaugteil zur Vereinfachung der zeichnerischen Darstellung weggelassen wurde. Die Pumpe P drückt die im Vorratsbehälter Vb angesaugte Behandlungsflüssigkeit über ein Regulierventil Rv2 und eine Zuführleitung Zl in ein in der Behandlungszelle unterhalb der Durchlaufbahn der Leiterplatten Lp angeordnetes Flutregister Fr. Dieses lediglich rein schematisch dargestellte Flutregister Fr erzeugt eine durch Pfeile St aufgezeigte nach oben gerichtete Strömung und gewährleistet somit eine gleichmäßige Durchflutung sämtlicher Durchkontaktierungslöcher der Leiterplatte Lp. Die Behandlungsflüssigkeit läuft dann in Richtung des Pfeiles Pfl über ein Wehr Wh in eine mit Aw bezeichnete Auffangwanne. Die Höhe des Wehres Wh definiert somit die Höhe des mit Fsl bezeichneten Flüssigkeitsspiegels in der Behandlungszelle Bz.

Die aus der Behandlungszelle Bz austretende und in der Auffangwanne Aw aufgefangene Behandlungsflüssigkeit wird über eine Abflußleitung Al in den darunter angeordneten Vorratsbehälter Vb zurückgeführt, so daß sich ein geschlossener Kreislauf mit einer kontinuierlichen Umwälzung der Behandlungsflüssigkeit ergibt.

Nach der Durchführung durch den Deckel D des Vorratsbehälters Vb mündet die Abflußleitung Al über einen insbesondere aus Fig. 2 ersichtlichen U-förmigen Bogen Bo von unten her in ein ringförmiges Verteilerrohr Vr ein. Dieses horizontal im Vorratsbehälter Vb angeordnete Verteilerrohr Vr weist an seiner Oberseite einen ringförmig umlaufenden Austrittsschlitz As auf, der knapp über dem mit Fs2 bezeichneten Flüssigkeitsspiegel der Behandlungsflüssigkeit im Vorratsbehäler Vr liegt. Die entsprechende Einstellung des Flüssigkeitsspiegels Fs2 kann beispielsweise über das Regulierventil Rv2 vorgenommen werden.

Die in den Vorratsbehälter Vb zurückgeführte Behandlungsflüssigkeit tritt dann dicht über dem Flüssigkeitsspiegel Fs durch den Austrittsschlitz As aus, so wie es in der Zeichnung durch Pfeile Pf2 aufgezeigt ist. Die Form und Lage des Austrittsschlitzes As begünstigt dabei ein Entweichen der mitgeführten Luft. Außerdem vergrößert der Austrittsschlitz As den Austrittsquerschnitt derart, daß durch die entsprechend verringerte Austrittsgeschwindigkeit der Behandlungsflüssigkeit keine merkliche Schaumbildung mehr hervorgerufen werden kann.

Ein in der Abflußleitung Al angeordnetes Regelventil Rvl kann so eingestellt werden, daß in der Abflußleitung Al eine bis zum Auslauf der Auffangwanne Aw reichende Flüssigkeitssäule aufgebaut wird. Durch diese Maßnahme wird im Auslaufbereich der Auffangwanne Aw ein Einarbeiten von Luft nach dem Prinzip der Wasserstrahlpumpe verhindert.

Bei der vorstehend geschilderten Behandlungseinrichtung kann selbst bei Behandlungsflüssigkeiten mit hohen Netzmittelgehalten eine störende Schaumbildung im Vorratsbehälter verhindert werden. Die geschilderten Maßnahmen zur Reduzierung bzw. Verhinderung der Schaumbildung haben sich bei der Behandlung von Leiterplatten in Reiniger-/Konditionierlösungen mit Netzmittelgehalten von ca. 25 % hervorragend bewährt. Eine Anwendung ist grundsätzlich in allen Fällen zu empfehlen, bei denen die Rückführung von Behandlungsflüssigkeiten in Vorratsbehälter oder auch in einen Sumpf zu einer störenden Schaumbildung führen könnte.

**Patentansprüche**

I. Behandlungseinrichtung, insbesondere für im horizontalen Durchlauf zu behandelnde Leiterplatten, mit einer Behandlungszelle welcher Behandlungsflüssigkeit aus einem Vorratsbehälter mittels einer Pumpe zuführbar ist und mit einer in den Vorratsbehälter einmündenden Abflußleitung für aus der Behandlungszelle austretende Behandlungsflüssigkeit, dadurch **gekennzeichnet**, daß die Abflußleitung (Al) an ein im Vorratsbehälter (Vb) angeordnetes Verteilerrohr (Vr) angeschlossen ist und daß das Verteilerrohr (Vr) mit mindestens einem oberhalb des Flüssigkeitsspiegels (Fs2) angeordneten Austrittsschlitz (As) ausgerüstet ist.

2. Behandlungseinrichtung nach Anspruch I, dadurch **gekennzeichnet**, daß die Abflußleitung (Al) über einen U-förmigen Bogen (Bo) von unten her in das Verteilerrohr (Vr) einmündet.

3. Behandlungseinrichtung nach Anspruch I oder 2, dadurch **gekennzeichnet**, daß das Ver-teilerrohr (Vr) die Form eines geschlossenen Ringes aufweist.

4. Behandlungseinrichtung nach einem der vorhergehenden Ansprüche, dadurch **gekennzeichnet**, daß das Verteilerrohr (Vr) mit einem durchgehenden Austrittsschlitz (As) ausgerüstet ist.

5. Behandlungseinrichtung nach einem der vorhergehenden Ansprüche, dadurch **gekennzeichnet**, daß das Verteilerrohr (Vr) einen kreisförmigen oder ovalen Querschnitt aufweist.

6. Behandlungseinrichtung nach einem der vorhergehenden Ansprüche, dadurch **gekennzeichnet**, daß in der Abflußleitung (Al) ein Regulierventil (Rvl) angeordnet ist.

7. Behandlungseinrichtung nach einem der vorhergehenden Ansprüche, dadurch **gekennzeichnet**, daß in der Zuführleitung (Zl) zwischen Pumpe (P) und Vorratsbehälter (Vb) ein Regulierventil (Rv2) angeordnet ist.

**Claims**

1. Treatment apparatus, particularly for printed-circuit boards moving horizontally, with a treatment compartment to which treatment liquid can be supplied from a reservoir by means of a pump, and with a drain pipe, which leads into the reservoir, for treatment liquid discharging from the treatment compartment, characterized in that the drain pipe (A1) is connected to a distributor pipe (Vr) arranged in the reservoir (Vb), and in that the distributor pipe (Vr) is equipped with at least one discharge slot (As) arranged above the liquid level (Fs2).

2. Treatment apparatus according to Claim 1, characterized in that the drain pipe (A1) leads from below into the distributor pipe (Vr) via a U-shaped bend (Bo).

3. Treatment apparatus according to Claim 1 to 2, characterized in that the distributor pipe (Vr) has the form of a closed ring.

4. Treatment apparatus according to one of the preceding claims, characterized in that the distributor pipe (Vr) is equippped with a continuous discharge slot (As).

5. Treatment apparatus according to one of the preceding claims, characterized in that the distributor pipe (Vr) has a circular or oval cross-section.

6. Treatment apparatus according to one of the preceding claims, characterized in that a control valve (Rv1) is arranged in the drain pipe (A1).

7. Treatment apparatus according to one of the preceding claims, characterized in that a control valve (Rv2) is arranged in the supply line (Z1) between pump (P) and reservoir (Vb).

**Revendications**

1. Installation de traitement, en particulier de plaques à circuits imprimés à traiter pendant leur défilement horizontal, comprenant une cellule de traitement qui peut être alimentée par une pompe en liquide de traitement à partir d'un réservoir, ainsi qu'une conduite de décharge de liquide de traitement sortant de la cellule et qui débouche dans le réservoir, caractérisée en ce que la conduite de décharge (A1) est raccordée à un tuyau répartiteur (Vr) placé dans le réservoir (Vb) et que le tuyau répartiteur (Vr) est pourvu d'au moins une fente de sortie (As) située au-dessus de la surface du liquide (Fs2).

2. Installation selon la revendication 1, caractérisée en ce que la conduite de décharge (A1) débouche par le bas dans le tuyau répartiteur (VR) à l'aide d'une partie de conduite courbée en U (Bo).

3. Installation selon la revendication 1 ou 2, caractérisée en ce que le tuyau répartiteur (Vr) affecte la forme d'un anneau fermé.

4. Installation selon l'une des revendications précédentes, caractérisée en ce que le tuyau répartiteur (Vr) est pourvu d'une fente de sortie (As) continue.

5. Installation selon l'une des revendications précédentes, caractérisée en ce que le tuyau répartiteur (Vr) présente une section droite circulaire ou ovale.

6. Installations selon l'une des revendications précédentes, caractérisée en ce qu'un robinet de réglage (Rv1) est monté dans la conduite de décharge (A1).

7. Installation selon une des revendications précédentes, caractérisée en ce qu'un robinet de réglage (Rv2) est monté dans la conduite d'alimentation (Z1) entre la pompe (P) et le réservoir (Vb).

# FIG 1

# FIG 2